Europäisches Patentamt

European Patent Office

Office européen des brevets

(11) Publication number: **0 545 302 A1**

# EUROPEAN PATENT APPLICATION

(21) Application number: **92120284.2**

(22) Date of filing: **27.11.92**

(51) Int. Cl.5: **H01L 39/24**, F02M 67/12, F02M 51/06

(30) Priority: **29.11.91 JP 315089/91**

(43) Date of publication of application:
**09.06.93 Bulletin 93/23**

(84) Designated Contracting States:
**DE FR GB**

(71) Applicant: **HITACHI, LTD.**
**6, Kanda Surugadai 4-chome**
**Chiyoda-ku, Tokyo 100(JP)**
Applicant: **INTERNATIONAL**
**SUPERCONDUCTIVITY TECHNOLOGY**
**CENTER**
**No. 34-3, Shinbashi 5-chome, Minato-ku**
**Tokyo 105(JP)**

(72) Inventor: **Higashiyama, Kazutoshi**
**18-2-301, Moriyamacho-3-chome**
**Hitachi-shi(JP)**
Inventor: **Hirabayashi, Izumi**
**9-3, Uesonocho-1-chome**
**Meito-ku, Nagoya-shi(JP)**
Inventor: **Morishita, Tadataka**
**553-1-I-1311, Shinanocho**
**Totsuka-ku, Yokohama-shi(JP)**
Inventor: **Tanaka, Shoji**
**5-23, Ichigaya Kagacho-2-chome**
**Shinjuku-ku, Tokyo(JP)**

(74) Representative: **Patentanwälte Beetz sen. -**
**Beetz jun. Timpe - Siegfried -**
**Schmitt-Fumian- Mayr**
**Steinsdorfstrasse 10**
**W-8000 München 22 (DE)**

(54) **Method and apparatus for monitoring oxide superconducting film.**

(57) In formation of an oxide superconducting film on various substrates by chemical vapor deposition (CVD), a film-growing process is monitored in situ by irradiating the growing oxide superconducting thin film surface on a substrate (5) alternately with s-polarized laser beam (28) and p-polarized laser beam (28) at the Brewster angle of the substrate (5) or film to measure the intensity of reflected laser beams. Thickness, growth rate and flatness or smoothness of a growing film can be monitored on the basis of measured intensity, whereby a flat and smooth, and uniform oxide superconducting thin film can be formed effectively with respect to the operation and economy.

F I G. I

## BACKGROUND OF THE INVENTION

The present invention relates to a method and an apparatus for monitoring an oxide superconducting thin film growing by chemical vapor deposition (CVD).

Quartz thickness monitors have been so far known to monitor the thickness or growth rate of a growing oxide superconducting thin film growing on a substrate in the deposition process, and also reflection high-energy electron diffraction (RHEED) has been also known to give information on the flatness or smoothness, or crystal orientation of a growing thin film in the deposition process.

These are all utilized in the formation of oxide superconducting thin films [see, for example, T. Shigaki et al: Appl. Phys. Lett., 58 (1991), 2039-2041]. Furthermore, a method for obtaining information on the properties of a growing film surface in the deposition process by a laser beam has been already reported [T. Makimoto et al: Jap. J. Appl. Phys. 29 (1980), L207-209].

Monitoring of film thickness by the quartz thickness monitor is widely used in the physical vapor deposition (PVD) such as sputtering, etc., but is not used in CVD, whose film-forming process is essentially different from that of PVD. That is, according to PVD, atom particles or ion particles are directly deposited on a substrate to form a thin film and thus the thickness of the thin film growing on the substrate can be monitored by detecting the weight of the thin film growing on a quartz thickness monitor provided near the substrate.

According to CVD, on the other hand, molecules adsorbed on a substrate are decomposed by heat energy, etc. to deposit only the desired element(s), and thus in order to detect the thickness of a thin film growing on the quartz thickness monitor, it is necessary to heat the quartz thickness monitor itself to the same temperature as that of the substrate, but it is quite difficult to heat it due to the heat resistance and resistance to chemical reaction of the quartz thickness monitor.

In-situ monitoring by the RHEED is very effective in various film-forming processes. It can determine the crystallographic orientation of a growing thin film and also flatness or smoothness of the thin film in the atomic layer order. However, the RHEED uses an electron beam as a probe, and thus inevitable modification of the thin film by electron beam irradiation has been a problem, and also the detection must be carried out under high vacuum conditions. Generally, the deposition pressure in the CVD process is as high as $1.33 \cdot 10^{-2}$-133 hPa ($10^{-2}$-100 Torr), and thus the RHEED is not applicable to CVD.

With development of in-situ monitoring techniques using a laser beam shown in the above-mentioned Jap. J. Appl. Phys. 29 (1990) L207-209, it has been possible to directly monitor even the CVD film-forming process, but these techniques are all used in the field of semiconductors such as GaAs, etc., where, for example, a visible p-polarized laser beam is led to a growing GaAs film at the Brewster angle of GaAs film as an incident angle to monitor its reflectivity.

Since the p-polarized laser beam is led to the GaAs film at the Brewster angle, reflection from the matrix crystals of the GaAs film disappears, and consequently changes in the reflectivity due to the light absorption of adsorbed species on the outermost growing film surface can be detected with a high sensitivity. That is, changes in the adsorbed species on the growing film surface and their existing form can be detected from the changes in the reflectivity.

The monitoring method according to the present invention is to detect thickness and growth rate of a growing thin film and flatness or smoothness of the film surface, and thus is quite different from the above-mentioned technique in the principle and kinds of information to be obtained.

In the field of producing optical thin films such as optical mirrors, etc., monitoring and control of film thickness by light are now in practice (see, for example, "Hikari Hakumaku Gizutsu Manual (Technical Manual of Optical Thin Film)", p 229, published by Optronics, Japan), where a monitor substrate for film thickness monitoring is provided in a film deposition chamber in advance and irradiated with light during the film growth and cyclic changes in the reflectivity due to an increase in the thickness of the thin film on the monitor substrate are detected, thereby to conduct the monitoring and control of the thin film. The proposed method is effective only for cases that the thin film is very flat or smooth, and uniform and undergoes substantially no light absorption, as in the case of optical thin films, but in the cases that the surface flatness or smoothness is poor, various heterophases exist, and the light absorption is not negligible, as in the case of oxide superconducting thin films, it is very hard to directly monitor the film thickness from changes in the reflectivity and control the film thickness.

As described above, a means of irradiating an oxide superconducting thin film in the deposition process by CVD with a laser beam and monitoring the growth rate and film thickness of the growing thin film, and the flatness or smoothness of the thin film surface has not been so far known yet. This, to obtain a thin film of desired thickness, it has been so far necessary to obtain a relationship between the deposition time and the film thickness in advance. A means that can correspond to fluctuations in the growth rate due to deterioration of gas source materials, etc. in the deposition process has not been so far proposed yet, either. Since the growth of heterophases due to fluctuations in the composition or the film deposition conditions has a large influence upon a decrease in the surface flatness or smoothness of the thin film in the CVD process, it has been so far impossible to detect such a growth of heterophases during the deposition process.

## SUMMARY OF THE INVENTION

An object of the present invention is to provide a method and an apparatus for monitoring a growing oxide superconducting thin film, which can monitor a growth rate, a thickness and a surface flatness or smoothness of the film in-situ in the deposition process.

To solve the problems, the present invention provides a method for monitoring an oxide superconducting thin film growing on a substrate by chemical vapor deposition, which comprises irradiating an oxide superconducting thin film growing on the substrate with a laser beam, and measuring an intensity of reflected laser beam from the irradiated thin film, thereby monitoring a growth rate, a thickness and a surface flatness or smoothness of the growing oxide superconducting thin film.

Furthermore, the present invention provides an apparatus for monitoring a growing oxide superconducting thin film in a film-depositing chamber provided with a pair of optical window for an incident light and an optical window for a reflected light, counterposed to each other at a specific angle to a heated substrate, which comprises a laser irradiation system comprising a laser, a polarizer, a 1/2 waveplate and its accessary motor and an optical chopper successively arranged on the side of the optical window for the incident laser beam, and with a reflected laser beam detector comprising an iris diaphragm and a photodiode, successively arranged on the side of the optical window for the reflected laser beam, a lock-in amplifier connected to the chopper and the photodiode, and a unit for computing signals from the lock-in amplifier.

## BRIEF DESCRIPTION OF THE DRAWINGS

Fig. 1 is a schematic view of an apparatus for monitoring a growing oxide superconducting film according to the present invention.

Fig. 2 is a diagram showing changes in the intensity of reflected laser beam detected in Example 1 according to the present invention.

Fig. 3 is a diagram showing changes in the intensity of reflected laser beam detected in Example 2 according to the present invention.

Fig. 4 is a diagram showing changes in the intensity of reflected laser beam detected in Example 3 according to the present invention.

Fig. 5 is a diagram showing flatness or smoothness of thin films obtained in Example 4 according to the present invention.

Fig. 6 is a comparative diagram between the film growth rate obtained in Example 5 according to the present invention and the actual growth rate.

Fig. 7 is a schematic view showing optical paths when a film growing on a substrate is irradiated with a laser beam.

Fig. 8 is a schematic view showing optical paths when a p-polarized laser beam is irradiated at the Brewster angle of a substrate.

Fig. 9 is a schematic view showing optical paths when p-polarized laser beam is irradiated at the Brewster angle of a film material.

## DETAINED DESCRIPTION OF THE INVENTION

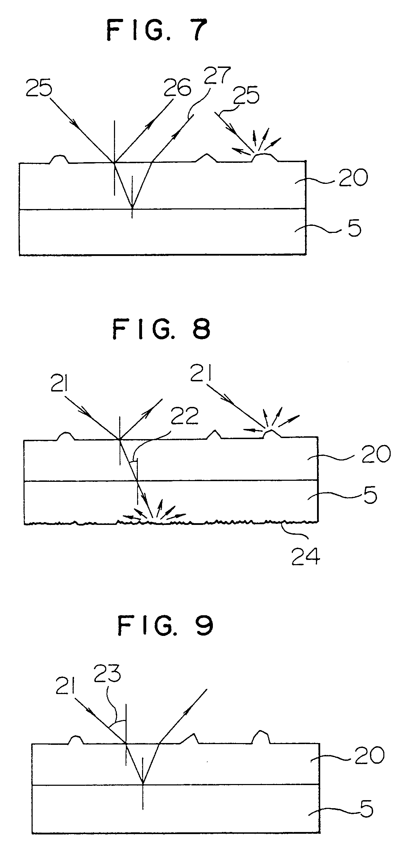

Fig. 7 is a schematic view of optical paths when a thin film growing on a substrate is irradiated with a laser beam, where numeral 5 is a substrate, 20 a growing oxide superconducting thin film, 25 a laser beam, 26 a reflected laser beam from the film surface, and 27 a reflected laser beam from the substrate surface. When the oxide superconducting thin film 20 growing on the substrate 5 is irradiated with the laser beam 25 having a wavelength $\lambda_1$, a phase difference appears between the reflected laser beam 26 from the upper surface of the film 20 and the reflected laser beam 27 from the lower surface of the film 20.

The phase difference $\delta$ of the laser beams can be given by the following equation:

$$\delta = 2\pi/\lambda_1 \cdot 2 \cdot n \cdot d \cdot \cos\chi \pm \pi \qquad (1)$$

where $\lambda_1$ is a laser wavelength, n a refractive index of the film, d a film thickness and $\chi$ an incident angle of the laser beam into the film.

With increasing film thickness d, the phase difference $\delta$ increases, and when $\delta$ takes $2\pi$ multiplied by an integral number, the intensity of reflected laser beam will be a maximum due to an interference, whereas it will be a minimum when $\delta$ is deviated therefrom by $\pi$. As a result, the intensity of reflected laser beam oscillates at definite cycles corresponding to the film growth rate. The film thickness, when the intensity of reflected laser beam is a maximum or a minimum, is proportional to 1/4 of the wavelength of a laser beam, as is obvious from the equation (1). Thus, it is possible to monitor the film thickness and the film growth rate by determining individual peak values.

With increasing film thickness, oscillation amplitude of reflected laser beam will decrease and reflectivity will decrease, because with increasing film thickness, absorption of transmitted laser beam by the film will increase and also with increasing roughness of the film surface, the laser beam will be scattered. Absorption of laser beam by the thin film is a function of film thickness, and it is thus possible to monitor the flatness or smoothness of film surface from decreasing rates of the intensity of reflected laser beam obtained by computing it.

Changes in the intensity of reflected laser beam can be likewise analyzed, irrespective of the wavelength, incident angle, etc. of laser beam except for special cases. One example of the special cases is a case that a p-polarized laser beam is led to the film or the substrate at their respective Brewster angles, where changes in the intensity of reflected laser beam are widely different from those of the foregoing cases. The Brewster angle $\theta_1$ of each material can be calculated by the following equation:

$$\theta_1 = \tan n_2/n_1 \qquad (2)$$

where $n_2$ is a refractive index of a material and $n_1$ is a refractive index of a substance in contact with the material. When a laser beam is usually led into a substance at that angle, p-polarized components are all transmitted threthrough. Fig. 8 is a schematic view showing optical paths when a p-polarized laser beam is led to the thin film at the Brewster angle of the substrate, where numeral 21 is the p-polarized laser beam and 22 the Brewster angle. That is, Fig. 8 shows a case where the p-polarized laser beam 21 is led to the substrate 20 at the Brewster angle 22. In that case, there is no reflection from the lower surface of growing oxide superconducting thin film 20 and the reflected laser beam to be detected is only that from the upper surface of the growing thin film.

As a result, no cyclic oscillation is observed in the intensity of reflected laser beam due to the interference, and the decrease in the intensity of reflected laser beam due to the absorption of the thin film itself is small. Thus, changes in the intensity of reflected laser beam are substantially due to scattering of the laser beam on the film surface, that is, the changes in the intensity highly reflect only the surface roughness. Thus, when the p-polarized laser beam and the s-polarized laser beam are alternately led to the growing thin film at the angle that satisfies the conditions of Fig. 8 and changes in the intensity of reflected laser beam are recorded for each of p-polarized laser beam and s-polarized laser beam, the flatness or smoothness of the thin film can be monitored substantially in real time from changes in the intensity of reflected p-polarized laser beam, and likewise the film thickness and the growth rate of growing thin film can be monitored from changes in the intensity of reflected s-polarized laser beam. By combination of detection with the p-polarized laser beam with that with the s-polarized laser beam, more accurate monitoring can be carried out.

Fig. 9 is a schematic view showing an optical path when a p-polarized laser beam is led to the film at the Brewster angle of the thin film material. Substantially the same results can be obtained also when the p-polarized laser beam 21 is led thereto at the Brewster angle 23 of the growing oxide superconducting thin film, except for the following difference from the case of irradiation at the Brewster angle of the substrate as shown in Fig. 8. That is, in this case, substantially no reflection takes place on the upper surface of the growing oxide superconducting thin film, and the reflected laser beam from the interface between the thin film and the substrate is dominant. No interference occurs likewise, but the intensity of the reflected laser beam contains influences of scattering of laser beam on the film surface and within the thin film, and also absorption of the thin film itself. Thus, this procedure is effective when a substrate is opaque and the incidence of the laser beam at the Brewster angle of the substrate is not important, or when the flatness or smoothness of a growing oxide superconducting thin film is very high and sizes of crystal grains constituting the thin film (frequency in distribution of crystal grain boundary) is to be evaluated rather than the surface roughness.

PREFERRED EMBODIMENTS OF THE INVENTION

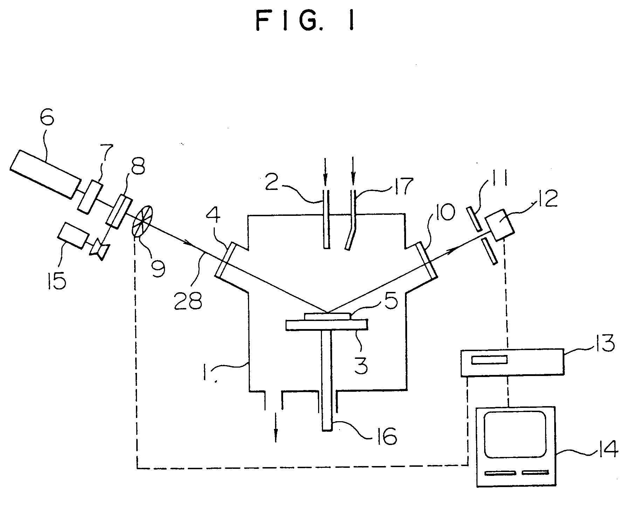

The present invention will be explained in detail below, referring to Figs. 1 to 6.

Fig. 1 is a schematic view showing an apparatus for monitoring a growing oxide superconducting thin film according to the present invention, where numeral 1 is a reactor chamber, 2 a source gas supply nozzle, 3 a heater, 4 a laser inlet window, 5 a substrate, 6 a laser emitter, 7 a polarizer, 8 a 1/2 waveplate, 9 a chopper, 10 a laser outlet window, 11 an iris diaphragm, 12 a detector, 13 a lock-in amplifier, 14 a computer, 15 a monitor, 16 a support rotor, and 17 a gas inlet nozzle.

The structure of the present apparatus will be explained, referring to Fig. 1.

A heater 3 for working on the substrate 5 is provided at a position near a source gas supply nozzle 2 in the reactor chamber 1, so that the substrate 5 can be placed on the heater 3. On the other hand, the laser emitter 6 is so arranged that the substrate 5 can be irradiated with the laser beam 28 through the laser inlet window 4 of the reactor chamber 1. The polarizer 7, the 1/2 waveplate 8 and the chopper 9 are provided on the optical path in this order between the laser emitter 6 and the laser inlet window 4.

The laser beam 28 reflected from the substrate 5 is passed through the laser outlet window 10. The iris diaphragm 11 for cutting a room light and the silicon diode detector 12 are provided on the optical path after the laser outlet window 10, and an output from the silicon diode detector is led to a computer 14 through a lock-in amplifier 13. The 1/2 waveplate 8 can be rotated by a motor 15, whereby the polarization plane of laser beam can be shifted as desired. The heater 3 is placed on a support rotor 16, which can be horizontally moved to adjust the incident angle of the laser beam and also to rotate the substrate 5.

A process for forming an oxide superconducting thin film will be explained below. A $YBa_2Cu_3Ox$ film was formed on a MgO (100) single crystal substrate (single side mirror). Conditions for the film formation are as follows. As source materials, $\beta$-diketone complexes, i.e. $Y(thd)_3$, $Ba(thd)_2$, and $Cu(thd)_2$ were used, where thd means 2,2,6,6-tetramethyl-3,5-heptanedione.

Heating temperatures for the respective source materials were 117°C, 225°C and 101°C in that order, and flow rates of the respective carrier gases ($N_2$) were 44, 50 and 44 cc/min, while 600 cc/min of $O_2$ was supplied into the reactor chamber 1 through another gas inlet nozzle 17. Pressure during the film growth in the reactor chamber 1 was 8 hPa (6.0 Torr), the substrate temperature 750°C and film deposition time 2 hours.

As laser light sources, a He-Ne laser (wavelength: 632.8 nm) and an Ar laser (wavelength: 514.5 nm and 457.9 nm) were used, while the intensity of all the laser beams was set to 15 mW. All the laser beams 28 had a diameter of 2 mm. The laser beam was irradiated onto the substrate before the start to form a thin film, and recording of the intensity of the reflected laser beam was started. At the same time when the thin film formation was ended, the detection was ended. After the end of the thin film formation, the thin film was cooled in an $O_2$ atmosphere under 1013 hPa (1 atm).

The intensity of reflected laser beam was detected under detection conditions given in the following Examples while forming a $YBa_2Cu_3Ox$ film under the above-mentioned film-forming conditions.

Example 1

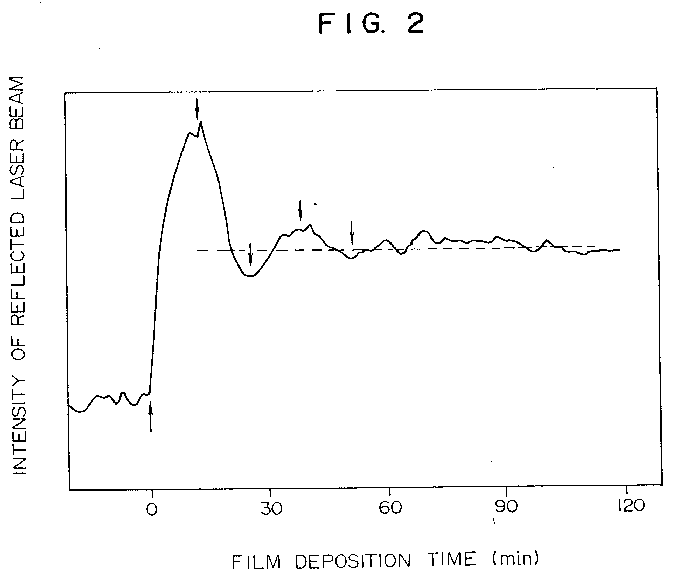

Changes in the intensity of reflected laser beam when the s-polarized He-Ne laser beam was irradiated onto the growing thin film at an incident angle of 78° are shown in Fig. 2, where clear maximum and minimum are observed 13.5 min.,

26.5 min., 39.3 min and 521. min after the start of film formation.

The film thickness d (nm) at the maximum point was calculated from the equation (1) and it was found that d = 0.079(2m-1). The film thickness at the minimum points were also found to be d = 0.079(2m). Film growth rates calculated therefrom all show a constant value, i.e. 0.035 $\mu$m/h.

The growth rate of the $YBa_2Cu_3Ox$ film actually prepared was 0.30 $\mu$m/h, which was substantially in good agreement with the calculated ones. It was found from surface pictures of the film that the film surface was substantially flat and smooth.

The base line (dashed line) of the intensity curve as shown in Fig. 2, which was obtained by eliminating the oscillatory components in the time dependence of the reflective intensity, was parallel to the abscissa.

Example 2

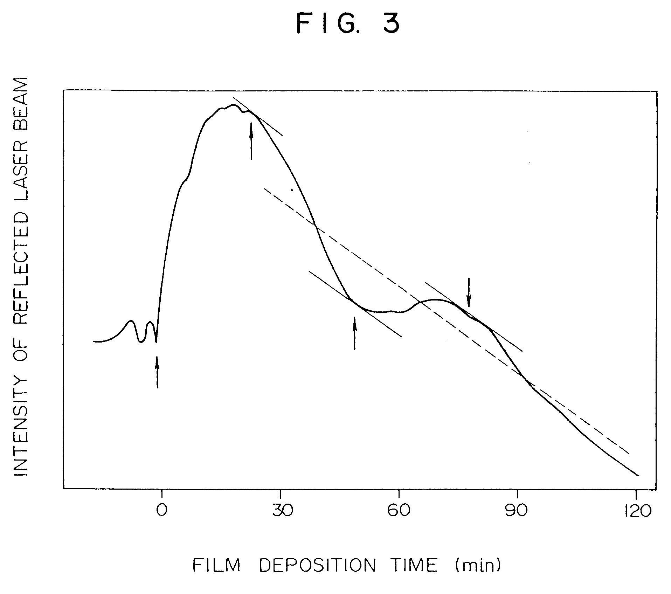

A s-polarized He-Ne laser beam was irradiated onto the growing thin film at an incident angle of 78° in the same manner as in Example 1, and the results of the detected intensity of reflected laser beam are shown in Fig. 3. In this Example, deposition or precipitation of a large number of grains was observed on the film surface. It can be seen from the intensity of reflected laser beam shown in Fig. 3 that its absolute value 3 were abruptly lowered due to influences of scattering of laser beam by the grains. As a result of the scattering of the laser beam by the grains, the peak positions of Fig. 3 were expected to deviate from the actual positions. To adjust the deviations, tangents in parallel to a base line (dashed line) were drawn to obtain accurate peak positions. The peak positions were 18.7 min., 54.3 min. and 70.9 min. before the adjustment, whereas as a result of the adjustment the peak positions were corrected to 24.2 min., 50.5 min. and 78.4 min. respectively, and the corrected peak positions were substantially at equal distances therebetween. The film growth rate obtained from these values was 0.17 $\mu$m/h, which was substantially in good agreement with the actual growth rate of 0.14 $\mu$m/h.

When the film surface is rough due to the precipitated grains, etc., the base line of the intensity of reflected laser beam will have some inclination. In this case, the above-mentioned adjustment must be made to calculate the film thickness or growth rate from the peak positions.

Example 3

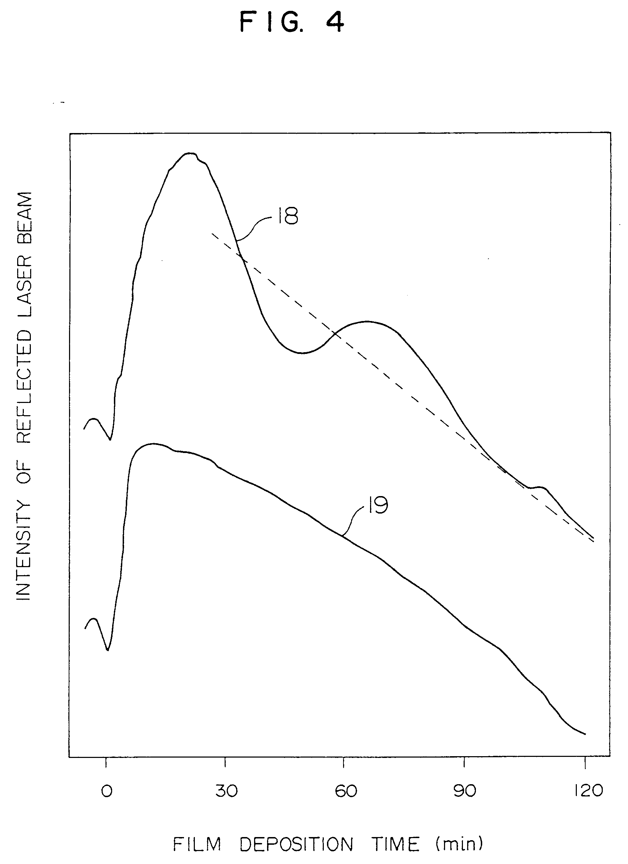

In this Example, the intensity of reflected laser beam was measured by changing the polarization plane of a He-Ne laser beam alternately to 0° or 90° (i.e. p-polarized laser beam or s-polarized laser beam) at every 2 seconds by the 1/2 waveplate shown in Fig. 1. The incident angle of laser beam was adjusted to satisfy the conditions of Fig. 8. The results are shown in Fig. 4, where numeral 18 is a curve showing changes in the intensity of reflected s-polarized laser beam and 19 is a curve showing changes in the intensity of reflected p-polarized laser beam. A large number of grain precipitates were observed on the film surface, as in Example 2.

As a result, it was found that the base line for the curve 18 showing changes in the intensity of reflected s-polarized laser beam of Fig. 4 declined likewise. On the other hand, the curve 19 showing changes in the intensity of reflected p-polarized laser beam had substantially no peaks as observed in case of the curve 18, and the intensity of reflected p-polarized laser beam decreased simply. When a p-polarized laser beam adjusted to the Brewster angle of the substrate, as shown in Fig. 8, is led to the growing thin film, only reflected laser beam from the film surface can be detected, and thus changes in the intensity directly reflect the roughness of the film surface.

When the peak positions are to be determined from the curve 18 showing changes in the intensity of reflected s-polarized laser beam, the curve 19 showing the changes in the intensity of reflected p-polarized laser beam directly correspond to fluctuations of the base line, and thus more accurate peak positions can be determined and the film growth rate can be calculated therefrom. The film growth rate obtained from the intensity of the reflected laser beam was 0.20 $\mu$m/h, whereas the actual film growth rate was 0.18 $\mu$m/h.

When the s-polarized He-Ne laser beam was irradiated onto the film at an incident angle of 78°, base lines were obtained by eliminating the oscillatory components in the time dependence of the reflectivity, as shown in Figs. 2 and 3. The slope of the base line plotted as a function of Cu content in the film also gave a similar line to that of Fig. 4.

Example 4

Thin films having higher Cu contents were formed by changing the heating temperature of Cu $(thd)_2$ source material, and tested, where changes in the intensity of reflected p-polarized laser beam were measured. As the laser beam, a He-Ne laser beam was used and the incident angle of the laser beam onto the MgO substrate in the film growth process was adjusted to the Brewster angle of MgO. A ratio of [Y]/[Ba] of the film was kept constant at 1/2.

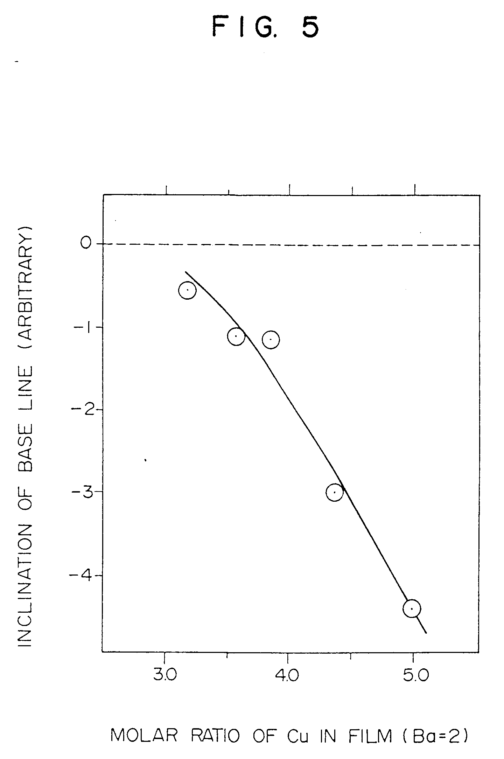

The curve showing changes in the reflected laser beam was approximated by a straight line and the inclination of the straight line was plotted against Cu molar ratios of the thin films (where the Ba content was fixed to 2). The results are shown in Fig. 5. From pictures of film surfaces, it was found that the amount of precipitated grains (mainly of CuO) increased with increasing Cu content. The inclination of the curve showing the changes in the intensity of reflected laser beam was decreased correspondingly, as is apparent from Fig. 5.

Example 5

Measurement was carried out with an Ar laser (wavelength $\lambda$ = 514.5 nm and 457.9 nm) capable of emitting a laser beam having a shorter wavelength than that of He-Ne laser (wavelength $\lambda$ = 632.8 nm) under similar measurement conditions to those of Example 3.

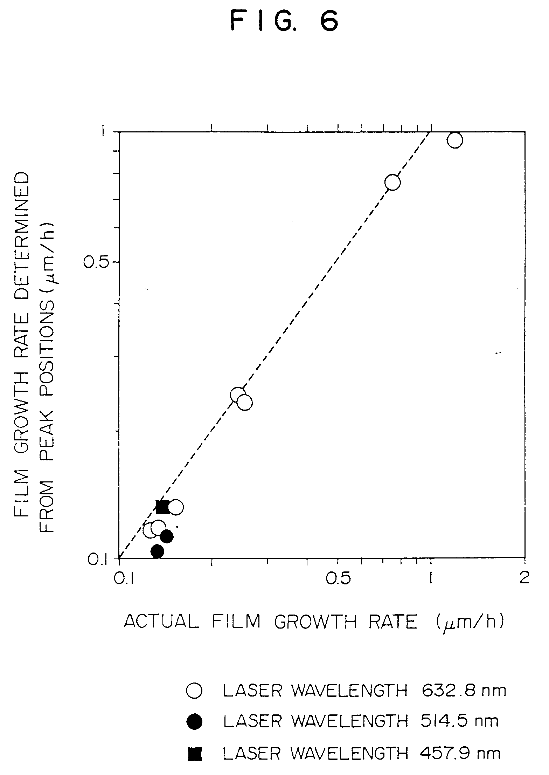

Results of comparison of film growth rates calculated from peak positions of the curve showing changes in the intensity of reflected laser beams with actual film growth rates are shown in Fig. 6, where the results with the He-Ne laser beam are also shown together.

Both calculated values and actual values of film growth rate were substantially in good agreement with one another. When a laser beam of shorter wavelength is used, peaks of thin films having smaller film thickness can be detected, and thus the film growth rate can be determined earlier after the start to form the thin film.

In the foregoing Examples, MgO was used as a substrate material. Not only MgO, but also various substrate materials such as $SrTiO_3$, $LaAlO_3$, $LaGaO_3$, $Al_2O_3$, Si, $SiO_2$, $NdGaO_3$, yttrium-stabilized zironia, etc. can be used for the same detection as above.

Most of single crystal substrates composed of the above-mentioned materials are transparent, whereas polycrystalline substrates of the same materials as mentioned above and various metal substrates are opaque. Thus, even if the p-polarized laser beam is led thereto at the Brewster angle, no such measurement as in Example 4 can be carried out. In that case, substantially similar results can be obtained by irradiation of the p-polarized laser beam at the Brewster angle of the film in place of the Brewster angle of the substrate. Furthermore, similar results can be obtained by making the incident angle of the laser beam equal to the Brewster angle of the film in Examples 3 and 4.

When the shape of grain precipitates has a constant regularity in the configuration, the shape and the configuration can be determined by rotating the substrate within the substrate plane during the deposition process. Furthermore, when the thin film itself has an optical anisotropy, the crystal orientation of the thin film can be determined by rotating the substrate likewise.

When various films are successively deposited on a substrate one upon another, or when atomic layers constituting an oxide superconducting thin film of single species are deposited on a substrate layer upon layer, the present invention can be also used.

By computing the outputs from the detector in parallel with the film formation shown in Examples, the present invention can be utilized to control film forming conditions successively.

In the present invention, measurement can be carried out in non-contact and non-destructive states, using a laser beam, and thus the present invention can be applied to film-forming apparatuses of any structure, so long as there are ports of leading a laser beam onto the film surface and taking out the reflected laser beam therefrom, respectively. Furthermore, the present invention can be applied to film formation not only by CVD, but also by PVD such as magnetron sputtering, laser sputtering, MBE, etc.

Any of ultraviolet light, visible light and infrared light can be used as a laser beam in the present invention and thus the light species can be selected in view of the desired species of oxide superconducting thin films, desired species of substrate, desired procedure for measurement, etc. The irradiation intensity of the laser beam is selected in view of the sensitivity of a detector for reflected laser beam and loss on the laser optical path, and can be increased within such a limit as not to deteriorate the film properties by the irradiation. To increase the S/N ratio of measurements, a chopper can be provided on the laser optical path, and the detector outputs can be measured by a lock-in amplifier synchronized with the chopper.

According to the present invention, the thickness, growth rate and flatness or smoothness of a growing thin film in the growth process can be readily monitored. A laser beam having a low intensity can be used, and thus the detection can be carried out without deteriorating the film properties. The growth rate of the growing thin film can be detected, and thus a quick response to fluctuations in the growth rate, if any, can be made and occurrence of second phase precipitates or particles can be monitored and furthermore the film-forming conditions can be properly controlled.

By monitoring with the present apparatus, working efficiency can be improved to enhance the economy of film formation.

## Claims

1. A method for monitoring an oxide superconductting thin film growing on a substrate (5) by chemical vapor deposition, which comprises irradiating an oxide superconducting thin film growing on the substrate (5) with a laser beam (28), and measuring an intensity of reflected laser beam from the irradiated thin film, thereby monitoring a growth rate, a thickness and a surface flatness or smoothness of the growing oxide superconducting thin film.

2. A method for monitoring an oxide superconducting film according to Claim 1, wherein the laser beam (28) is a linearly polarized laser beam, whose polarization plane is at an angle of $0°$ or $90°$ to the incident plane of the laser light or at an angle alternately changing to $0°$ or $90°$.

3. A method according to any one of Claims 1 and 2, wherein an incident angle of the laser beam (21) to the substrate (5) is the Brewster angle (22) of the substrate (5).

4. A method according to any one of Claims 1 and 2, wherein an incident angle of the laser beam (21) to the oxide superconducting thin film (20) is the Brewster angle (23) of the thin film (20).

5. An apparatus for monitoring an oxide superconducting thin film in a film-depositing chamber (1) provided with a pair of an optical window (4) for an incident laser beam (28) and an optical window (10) for a reflected laser beam, counterposed to each other, at a specific angle to a heated substrate (5), which comprises a laser irradiation system comprising a laser (6), a polarizer (7), a 1/2 waveplate (8) and its accessary motor and an optical chopper (9) successively arranged on the side of the optical window (4) for the incident laser beam (28), and with a reflected laser beam detector comprising an iris diaphragm (11) and a photodiode (12), successively arranged on the side of the optical window (10) for the reflected laser beam, a lock-in amplifier (13) connected to the chopper (9) and the photodiode (12), and a computer (14) for processing signals from the lock-in amplifier (13).

# F I G. I

EP 0 545 302 A1

# FIG. 2

INTENSITY OF REFLECTED LASER BEAM

FILM DEPOSITION TIME (min)

FIG. 3

FILM DEPOSITION TIME (min)

INTENSITY OF REFLECTED LASER BEAM

# F I G. 4

# FIG. 5

MOLAR RATIO OF Cu IN FILM (Ba=2)

# F I G. 6

LASER WAVELENGTH  632.8 nm

LASER WAVELENGTH  514.5 nm

LASER WAVELENGTH  457.9 nm

## FIG. 7

## FIG. 8

## FIG. 9

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | SOLID STATE COMMUNICATIONS vol. 77, no. 9, March 1991, NEW YORK, US pages 683 - 687 HABERMEIER H.U. 'The growth of (110) Y-Ba-Cu-O Thin Films and their Characterization by Optical Methods' * page 685, paragraph 2 - page 686, paragraph 6 * | 1-5 | H01L39/24 |
| A | JOURNAL OF VACUUM SCIENCE & TECHNOLOGY B vol. 7, no. 2, March 1989, NEW YORK, US pages 319 - 323 ECKSTEIN J.N. ET AL 'Epitaxial growth of high-temperature superconducting thin films' * page 319, paragraph 3 - page 320, paragraph 2; figure 1 * | 1 | |
| A | EP-A-0 426 570 (SUMITOMO ELECTRIC INDUSTRIES, LTD.) * page 4, line 13 - line 50 * * claims 1-7; figure 1 * | 1 | |
| P,A | EP-A-0 484 879 (NIHON SHINKU GIJUTSU KABUSHIKI KAISHA) * claims 1-7; figure 1 * | 1-5 | |

TECHNICAL FIELDS SEARCHED (Int. Cl.5 )

H01L
G01N

The present search report has been drawn up for all claims

| Place of search | Date of completion of the search | Examiner |
|---|---|---|
| THE HAGUE | 08 APRIL 1993 | HAMMEL E.J. |